# EUROPEAN PATENT APPLICATION

(11) **EP 4 814 513 A1**
(43) Date of publication of application: **30.09.2026**
(21) Application number: 26164981.8
(22) Date of filing: 16.03.2026
(51) Int. Cl.: G01R 31/392, B60L 58/16, G01R 31/389

(54) **BATTERY CONTROL DEVICE AND OPERATING METHOD OF BATTERY CONTROL DEVICE**

(30) Priority: 18.03.2025 KR 20250034849
(71) Applicant: SAMSUNG SDI CO., LTD., Yongin-si, Gyeonggi-do 17084 (KR)
(72) Inventor: OH, Seiyoung, 17084 Yongin-si, Gyeonggi-do (KR); LEE, Jangwoo, 17084 Yongin-si, Gyeonggi-do (KR); PARK, Joonho, 17084 Yongin-si, Gyeonggi-do (KR)
(74) Representative: Gulde & Partner

(57) **Abstract**

A battery system (1) according to the present disclosure includes a battery module (10) including a plurality of battery cells (11), and a battery control apparatus (20) that detects a plurality of battery data (B_DATA) indicating status of the plurality of battery cells (11) through electrochemical impedance spectroscopy for the plurality of battery cells (11), generates a degradation profile (USER A, USER B) of the plurality of battery cells (11) based on the plurality of battery data, and controls use conditions of the plurality of battery cells (11) based on a comparison result of the degradation profile (USER A, USER B) and a reference degradation profile (ref).

## Description

### FIELD

The present disclosure relates to a battery control apparatus and an operating method thereof.

### BACKGROUND

A rechargeable battery is a battery that can be charged and discharged, unlike a primary battery that cannot be recharged. Low-capacity rechargeable batteries are used in small portable electronic devices such as smartphones, feature phones, laptop computers, digital cameras, and camcorders, and high-capacity rechargeable batteries are widely used as motor driving power for hybrid vehicles and electric vehicles and power source of power storage devices.

The lifespan of the rechargeable battery varies according to the usage pattern of the user. For example, in the case of a rechargeable battery used in a vehicle, a period in which a user can use a battery varies according to the driving pattern of a user. In order to guarantee the battery guarantee period, the battery manufacturer may predict the lifespan of the battery according to the driving pattern of the user and control the usage condition of the battery according to the driving pattern of the user.

An electrochemical impedance spectroscopy EIS method measures impedance of a battery by analyzing a current and a voltage response of a battery after applying an AC signal of various frequency bands to a battery. Since electrochemical impedance spectroscopy changes sensitively according to characteristics of a battery, it is possible to provide main information necessary for predicting the lifespan of a battery.

The herein-described information disclosed in the background technology of this disclosure is only intended to enhance the understanding of the background of the present disclosure and therefore may include information that does not constitute prior art.

### SUMMARY

The present disclosure is directed to provide a battery control apparatus for predicting the lifespan of a battery according to a driving pattern of a user and controlling a usage condition of the battery according to the driving pattern of the user, and an operating method thereof.

However, the technical problem to be solved by the present disclosure is not limited to the problems described herein, and other tasks not mentioned may be clearly understood by those skilled in the art from the description of the disclosure described herein.

A battery system according to the present disclosure includes a battery module including a plurality of battery cells, and a battery control apparatus that is configured to detect a plurality of battery data indicating status of the plurality of battery cells through electrochemical impedance spectroscopy EIS for the plurality of battery cells, to generate a degradation profile of the plurality of battery cells based on the plurality of battery data, and to control a usage condition of the plurality of battery cells based on a comparison result of the degradation profile and a reference degradation profile. Hence, the lifespan may be determined more precisely and may be prevented from unnecessary degradation by controlling the usage conditions. The lifespan may be the time between initial operation of the battery and when the battery capacity falls below a predetermined value, e.g. 80 % or 70 % of the capacity at the initial operation.

The battery control apparatus may be configured to predict the lifespan of the plurality of battery cells using a lifespan prediction model based on the plurality of battery data. The lifespan prediction model may be configured to predict the lifespan based on different pluralities of battery data. An advantage of this embodiment may be that a complex lifespan prediction model, once established, can be used for every battery system that corresponds to the battery system that is used to generate or model the different pluralities of battery data.

The battery control apparatus may be configured to generate battery severity as a factor of the lifespan prediction model based on a plurality of combinations of reference data and a plurality of degradation data obtained as a simulation result for the plurality of combinations of reference data. An advantage of this embodiment may be that the lifespan or expected lifespan can be represented by a simple factor.

The reference data may comprise or be a plurality of battery data detected through electrochemical impedance spectroscopy, EIS, for a plurality of battery cells for simulation. An advantage of this embodiment may be that the lifespan can be determined based on data acquired by non-destructive measurement, i.e. by EIS.

The battery control apparatus may be configured to detect the plurality of battery data until a capacity throughput of the plurality of battery cells reaches a first value, and to predict a capacity change of the plurality of battery cells with respect to a portion where the capacity throughput exceeds the first value based on the plurality of battery data. An advantage of this embodiment may be that the plurality of battery data of different battery systems is comparable due to the detection at the first value.

The plurality of battery data may include voltage data, current data, and temperature data of the plurality of battery cells. An advantage of this embodiment may be that the data can be measured easily with usually already present sensors.

The degradation profile and the reference degradation profile may represent capacity change according to a capacity throughput of the plurality of battery cells. An advantage of this embodiment may be that a feature of the battery system that is to be determined, i.e. the lifespan, is determined based on the same physical feature, i.e. the trends of the capacity or the capacity change.

The usage conditions may include at least one of a maximum output current value of the plurality of battery cells, a state of charge SOC range, and a cooling degree for the plurality of battery cells. An advantage of this embodiment may be that these usage conditions usually are already determined when using the battery system.

The battery control apparatus may include a controller configured to detect the plurality of battery data, to generate the degradation profile, and to change the usage conditions of the plurality of battery cells based on a comparison result between the degradation profile and the reference degradation profile. The battery control apparatus may include a lifespan predictor configured to adjust values of the plurality of battery data according to the changed usage conditions, and to predict a lifespan of the plurality of battery cells using a lifespan prediction model based on the adjusted values of the plurality of data. The battery control apparatus may include a severity generator configured to generate a battery severity indicating a degree to which the plurality of battery data affects the lifespan of the plurality of battery cells as a coefficient of the lifespan prediction model. An advantage of this embodiment may be that the battery control apparatus may built in a modular manner and may thus be easily adaptable to different battery systems.

The controller may be configured to determine that a decreasing tendency of the degradation profile is greater than a decreasing tendency of the reference degradation profile by comparing the degradation profile with the reference degradation profile, to and analyze the user's driving tendency based on the plurality of battery data. An advantage of this embodiment may be that the controller's may be limited to case in which the decreasing tendency of the degradation profile is disadvantageous in view of user expectations that could be based on the reference degradation profile.

An operating method of a battery control apparatus according to the present disclosure includes receiving a plurality of battery data indicating status of a plurality battery cells obtained through electrochemical impedance spectroscopy EIS for the plurality of battery cells, generating a degradation profile of the plurality of battery cells based on the plurality of battery data, analyzing a driving tendency of a user based on the plurality of data, controlling usage conditions of the plurality of battery cells based on a comparison result of the degradation profile and a reference degradation profile of the plurality of battery cells and the driving tendency, and predicting a lifespan of the plurality of battery cells based on the usage conditions of the plurality of battery cells. Hence, the lifespan may be determined more precisely.

The degradation profile may represent a change in capacity according to the capacity throughput of the plurality of battery cells. The generating of the degradation profile of the plurality of battery cells may include at least one of, e.g. in the degradation profile indicating a change in capacity according to the capacity throughput of the plurality of battery cells, receiving the plurality of battery data until the capacity throughput reaches a first value, and calculating a change in capacity of the plurality of battery cells based on the plurality of battery data. An advantage of this embodiment may be that different battery systems can be analyzed and consequently operated according to the method in a comparable manner due to the detection at the first value.

The predicting the lifespan of the plurality of battery cells based on the usage conditions of the plurality of battery cells may include at least one of changing values of the plurality of battery data based on the usage conditions of the plurality of battery cells, and predicting a capacity change of the plurality of battery cells for a portion where the capacity throughput exceeds a first value based on the changed values of the plurality of battery data. An advantage of this embodiment may be that a feature of the battery system that is to be determined, i.e. the lifespan, is determined based on the same physical feature, i.e. the trends of the capacity or the capacity change.

The predicting of a capacity change of the plurality of battery cells with respect to a portion in which the capacity throughput exceeds the first value based on the changed values of the plurality of battery data may include at least one of generating a battery severity as a coefficient of the lifespan prediction model based on a plurality of combinations of reference data and a plurality of degradation data obtained as a simulation result of the plurality of combinations of the reference data, and predicting a capacity change of the plurality of battery cells using the lifespan prediction model based on the changed values of the plurality of battery data and the battery severity. An advantage of this embodiment may be that the lifespan or expected lifespan can be represented by a simple factor.

The reference data may be a plurality of battery data detected through electrochemical impedance spectroscopy, EIS, for a plurality of battery cells for simulation. An advantage of this embodiment may be that the lifespan can be determined based on data acquired by non-destructive measurement, i.e. by EIS.

The method may further include comparing the predicted capacity change with the reference degradation profile, and operating the plurality of battery cells according to usage conditions of the plurality of battery cells based on a result of comparing the predicted capacity change with the reference degradation profile. An advantage of this embodiment may be that the lifespan can be increased or at least hindered from being reduced by the usage conditions.

The controlling of the usage conditions of the plurality of battery cells based on the comparison result of the degradation profiles of the plurality of battery cells with the reference degradation profile and the driving tendency may include at least one of determining that a capacity decreasing tendency of the plurality of battery cells is greater than a capacity decreasing tendency by the reference degradation profile, and controlling at least one of a maximum output current value of the plurality of battery cells, an SOC range, and a cooling degree for the plurality of battery cells based on the driving tendency of the user. An advantage of this embodiment may be that these usage conditions usually are already determined when using the battery system.

Battery capacity throughput may be the total amount of energy a battery has stored and/or delivered over its time of operation, measured in kWh or MWh.

According to the present disclosure, it is possible to optimize the usage conditions of a battery and improve the performance of the battery in various battery usage patterns.

However, the effects obtainable through the present disclosure are not limited to the effects described herein, and other technical effects not mentioned will be clearly understood by those skilled in the art from the description of the disclosure described herein.

### BRIEF DESCRIPTION OF THE DRAWINGS

The following drawings attached to the present specification illustrate preferred embodiments of the present disclosure and serve to further understand the technical idea of the present disclosure together with the detailed description of the disclosure to be described herein, and thus the present disclosure should not be construed as being limited only to the matters set forth in the drawings.
FIG. 1 is a battery system according to some embodiments.
FIGS. 2A and 2B illustrate degradation profiles of a battery according to a battery usage pattern of a user.
FIG. 3 is a schematic block diagram of a battery control apparatus according to some embodiments.
FIG. 4 illustrates a controller according to some embodiments.
FIG. 5 illustrates a severity generator according to some embodiments.
FIG. 6 illustrates degradation data of a battery obtained during an experiment or simulation of a battery manufacturer.
FIG. 7 illustrates a lifespan predictor according to some embodiments.
FIG. 8 illustrates a predicted lifespan of a battery according to some embodiments.
FIG. 9 is a flowchart showing an operation method of a battery control apparatus according to some embodiments.
FIG. 10 illustrates a degradation profile of a battery according to some embodiments.
FIG. 11 illustrates a degradation profile of a battery according to some embodiments.

### DETAILED DESCRIPTION

Hereinafter, preferred embodiments of the present disclosure will be described in detail with reference to the accompanying drawings. As used in this specification, the terms "comprise" "include" and/or "comprising", "including" specify the presence of stated shapes, numbers, steps, operations, members, elements, and/or groups thereof, but do not preclude the presence or addition of one or more other shapes, numbers, steps, operations, members, elements, and/or groups thereof. In addition, when describing embodiments of the present disclosure, "~can be", "~may be" may include "one or more embodiments of the present disclosure".

In addition, in order to help understand the disclosure, the dimensions of some components may be exaggerated rather than the attached drawings shown at the actual scale. In addition, the same reference numbers may be assigned to the same components in different embodiments.

A reference to two items being "identical" means that they are "substantially identical". Also, the fact that any parameter is uniform in a predetermined region may mean that the parameter is uniform from an average viewpoint.

It will be understood that, although the terms first, second, etc. may be used herein to describe various elements, these elements should not be limited by these terms. These terms are only used to distinguish one component from another, and unless otherwise stated, the first component may be a second component.

Throughout the specification, each component may be singular or plural unless specifically opposed to the description.

The arrangement of any configuration in the " upper part(or lower part) " or " on(or below) " of a component may mean that any configuration is disposed in contact with the top surface (or bottom surface) of the component, as well as other configurations may be interposed between the component and any configuration disposed on (or under) the component.

It should also be understood that if a component is stated to be "coupled," "combined" or "connected" to another component, the components may be directly connected or connected to each other, but other components may be "interposed" between each component, or each component may be "coupled," "combined" or "connected" through another component. In addition, when a part is referred to as being electrically coupled to another part, it includes not only a case in which the part is directly connected, but also a case in which other elements are connected to each other with another element interposed therebetween.

Throughout the specification, when referred to as " A and/or B, " this means A, B, or A and B residues unless otherwise specified. That is, "and/or" includes any and all combinations of a plurality of items listed. When it comes to "C to D", it means that it is greater than or equal to C and less than D unless otherwise stated in opposition.

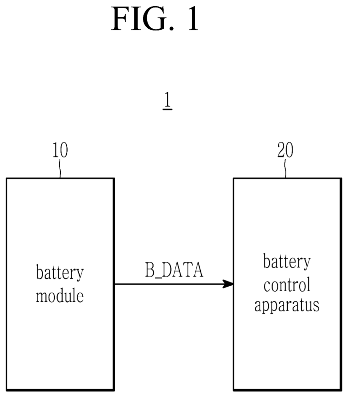

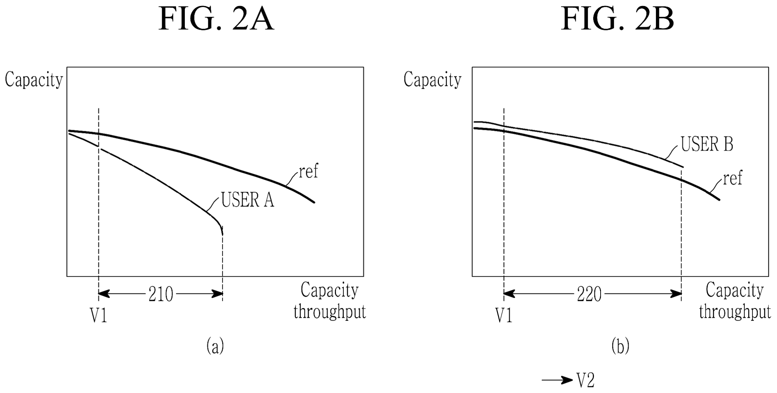

FIG. 1 illustrates a battery system according to some embodiments, and FIGS. 2A and 2B illustrate degradation profiles of a battery according to a battery usage pattern of a user.

Referring to FIG. 1, the battery system 1 according to some embodiments may include a battery module 10 and a battery control apparatus 20.

The battery module 10 may include a plurality of battery cells connected in series and/or in parallel with each other.

The battery control apparatus 20 may receive battery data B_DATA indicating the status of the battery according to the use of the battery from the battery module 10. Here, the battery data B_DATA may refer to the data collected by being measured in real time from the battery for a predetermined time. For example, the battery data B_DATA may include data obtained from EIS data and may include key information about the battery status. The battery control apparatus 20 may analyze the status of the battery or predict the lifespan of the battery by using the battery data B_DATA indicating the user's battery usage pattern. For example, the battery usage pattern may include a neglect pattern due to neglect of a vehicle including the battery system 1 and a driving pattern due to driving of the vehicle. The battery data B_DATA may include data representing the neglect pattern acquired when the user leaves the vehicle inactive, as well as data representing the driving pattern acquired when the user drives the vehicle.

EIS data may refer to data obtained through electrochemical impedance spectroscopy. The electrochemical impedance spectroscopy may be performed by applying AC signals of various frequencies to a battery cell and measuring voltage and current responses according to AC signals to detect impedance for each frequency band. Electrochemical impedance spectroscopy provides insight into the complex electrochemical characteristics inside a battery that cannot be determined simply by looking at the voltage and surface temperature of the battery cell.

In some embodiments, the battery data B_DATA may include a temperature inside the cell, an SOC status, and the like estimated based on the electrochemical characteristics inside the battery obtained from EIS data. For example, the battery data B_DATA may include voltage data of a battery cell, current data of a battery cell, temperature data inside the battery cell, state of charge SOC data, and the like. Hereinafter, for convenience of description, the battery data B_DATA is described as voltage data, current data, and temperature data of a battery cell, but the battery data B_DATA is not limited thereto.

In some embodiments, the battery control apparatus 20 may generate a degradation profile indicating a degradation status of the battery based on the battery data B_DATA. Specifically, the battery control apparatus 20 may receive the battery data B_DATA, monitor a change in the battery data B_DATA, and generate a degradation profile indicating a degradation status of the battery.

The battery manufacturer may determine in advance the battery usage pattern of the reference user to ensure the use of the battery during the warranty period during which the battery manufacturer guarantees the quality of the battery. The battery manufacturer may generate battery data indicating a battery usage pattern of a reference user in advance. In some embodiments, the battery control apparatus 20 may generate a reference degradation profile ref of the battery based on battery data according to the battery usage pattern of the reference user. Referring to FIGS. 2A and 2B together, FIG. 2A shows a reference degradation profile ref of a battery according to a battery usage pattern of a reference user (ref) and a degradation profile of a battery according to a battery usage pattern of a first user USER A, and FIG. 2B shows a reference degradation profile of a battery according to a battery usage pattern of a reference user and a degradation profile of a battery according to a battery usage pattern of a second user USER B. In graphs of FIGS. 2A and 2B, the horizontal axis indicates the capacity throughput of the battery, and the vertical axis indicates the capacity of the battery. As the battery capacity decreases, the battery lifespan becomes shorter. As the battery is degraded, the lifespan of the battery is reduced. As the degree of degradation of the battery increases, the capacity of the battery decreases rapidly.

In some embodiments, the battery control apparatus 20 may receive battery data B _ DATA according to the use of the battery from the battery module 10 until the capacity throughput of the battery becomes a predetermined value V1. The battery control apparatus 20 may output a change in the capacity of the battery as a degradation profile USER A, USER B until the capacity throughput of the battery becomes a predetermined value V1. Here, the fact that the capacity throughput of the battery becomes a predetermined value V1 may refer to a vehicle including the battery system 1 driving a predetermined distance but is not limited thereto.

In some embodiments, the battery control apparatus 20 may predict the lifespan of the battery according to the battery usage pattern based on the battery data B_DATA. Specifically, the battery control apparatus 20 may include a lifespan prediction model for predicting the lifespan of the battery and output the predicted lifespan of the battery according to the battery data B_DATA using the lifespan prediction model. The lifespan prediction model may be implemented by a mathematical function or a machine learning model.

Referring to FIGS. 2A and 2B, the battery control apparatus 20 may receive battery data B_DATA until the capacity throughput of the battery becomes a predetermined value V1, and predict the degree of degradation of the battery in the sections 210 and 220 in which the capacity throughput of the battery is greater than or equal to the predetermined value V1 by using a lifespan prediction model. The battery control apparatus 20 may predict the lifespan of the battery in sections 210 and 220 in which the capacity throughput of the battery is greater than or equal to a predetermined value V1 based on the battery data B_DATA. As shown in FIG. 2A, when the lifespan of the battery is predicted to be rapidly reduced, there is a problem in that the first user USER A may not use the battery for a warranty period guaranteed by the battery manufacturer. Therefore, it is necessary to analyze the user's driving tendency and control the battery usage conditions according to the user's driving tendency so that the lifespan of the battery does not decrease rapidly.

In some embodiments, the battery control apparatus 20 may analyze the driving tendency of the user based on the battery data B_DATA. Specifically, the battery control apparatus 20 may analyze the user's driving tendency based on the battery data B_DATA, such as determining the ratio of rapid acceleration section during the user's vehicle driving or the ratio of the vehicle's driving section and the neglect section based on the current change in the battery data B_DATA.

In some embodiments, the battery control apparatus 20 may compare the degradation profile USER A, USER B with the reference degradation profile ref of the battery, and control the user's battery usage condition based on the user's driving tendency and a comparison result between the degradation profile USER A, USER B and the reference degradation profile ref. Here, the battery usage condition may include a battery charging/discharging condition but is not limited thereto. For example, when the capacity of the battery of the first user USER A decreases relatively faster than the capacity of the battery of the reference user, the battery control apparatus 20 may lower the tendency to decrease the capacity of the battery by controlling the usage condition of the battery of the first user USER A according to the driving tendency of the user. That is, battery performance may be improved by optimizing battery usage conditions in various battery usage patterns of the user. Here, controlling the usage condition of the battery may include changing the maximum output current value of the battery, adjusting an SOC range of the battery, or changing a degree of cooling of the battery, but is not limited thereto.

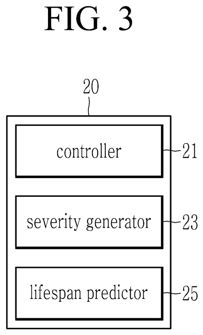

FIG. 3 is a schematic block diagram of a battery control apparatus according to some embodiments.

In some embodiments, the battery control apparatus 20 may include a controller 21, a severity generator 23, and a lifespan predictor 25. The controller 21 may control the user's battery usage condition by comparing the degradation profile of the battery with the reference degradation profile. The severity generator 23 may generate the battery severity as a factor used by the lifespan predictor 25 when predicting the lifespan of the battery using the lifespan prediction model. The lifespan predictor 25 may output a predicted lifespan of the battery based on battery data and battery severity. Hereinafter, each configuration of the battery control apparatus 20 will be described in detail.

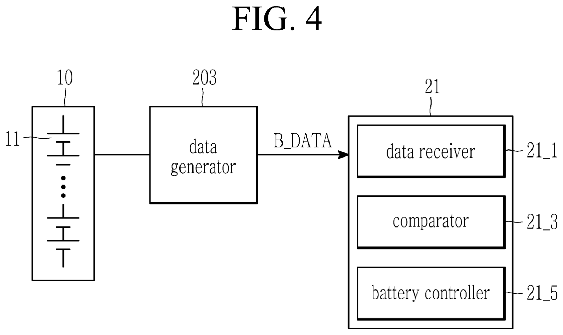

FIG. 4 illustrates a controller according to some embodiments.

In some embodiments, the battery module 10 may include a plurality of battery cells connected in series and/or in parallel with each other.

In some embodiments, the data generator 203 may detect the impedance of the battery cells 11 through electrochemical impedance spectroscopy. For example, the data generator 203 may generate AC signals of various frequencies to perform electrochemical impedance spectroscopy, apply AC signals to battery cells 11, and obtain impedance detected from voltage or current signals of each battery cell 11 as EIS data. In some embodiments, the data generator 203 may generate battery data B_DATA from EIS data. The data generator 203 may generate battery data B_DATA indicating the user's battery usage pattern based on the EIS data. The data generator 203 may generate voltage data, current data, and temperature data of the battery cell that change over time as the battery data B_DATA based on the electrochemical characteristics inside the battery obtained from the EIS data. In some embodiments, the data generator 203 may include a battery management system BMS, but is not limited thereto.

In some embodiments, the controller 21 may include a data receiver 21_1, a comparator 21_3, and a battery controller 21_5.

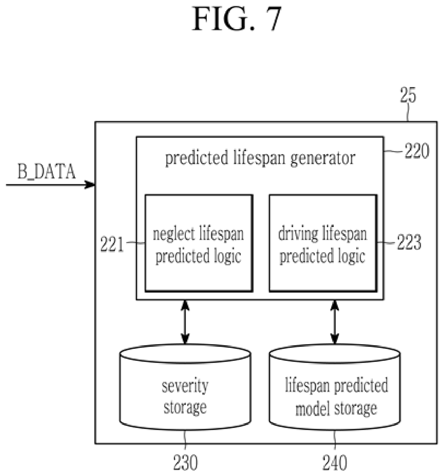

In some embodiments, the data receiver 21_1 may receive the battery data B_DATA as time progresses. For example, the data receiver 21_1 may receive battery data B_DATA from the data generator 203 through a data interface. The data receiver 21_1 may distinguish between a vehicle neglect status and a vehicle driving status based on the battery data B_DATA. For example, if the amount of current change is zero for a predetermined period of time, the data receiver 21_1 may determine that the corresponding time section is a vehicle neglect status. And the data receiver 21_1 may determine that the voltage data and temperature data corresponding to that time section is a battery data B_DATA acquired in the vehicle neglect status. The data receiver 21_1 may also transmit the received battery data B_DATA to the lifespan predictor 25 (of FIG. 3). A detailed description thereof will be described with reference to FIG. 7.

In some embodiments, the data receiver 21_1 may generate a degradation profile indicating a degradation status of the battery based on the battery data B_DATA. Specifically, the battery control apparatus 20 may receive the battery data B_DATA, monitor a change in the battery data B_DATA, and generate a degradation profile indicating a degradation status of the battery. The data receiver 21_1 may generate a degradation profile indicating changes in battery capacity based on battery data B_DATA acquired in both the vehicle neglect status and the vehicle driving status.

In some embodiments, the comparator 21_3 may compare the degradation profile of the battery according to the user's battery usage pattern and the reference degradation profile. As described with reference to FIGS. 2A and 2B, the degradation profile of the user and the reference degradation profile may be different from each other. In FIG. 2A, the capacity of the battery of the first user USER A decreases relatively faster than the capacity of the battery of the reference user(ref), and in FIG. 2B, the capacity of the battery of the second user USER B decreases relatively slower than the capacity of the battery of the reference user(ref). The comparator 21_3 according to some embodiments may compare the degradation profile of the battery according to the user's battery usage pattern and the reference degradation profile and determine that the capacity of the user's battery decreases relatively faster than the reference capacity.

In some embodiments, when the battery capacity of the user is reduced relatively faster than the reference capacity, the battery controller 21_5 may analyze the user's driving tendency based on the battery data B_DATA and control the user's battery usage condition to reduce the battery capacity decreasing tendency. Specifically, the battery controller 21_5 may analyze the user's driving tendency based on the battery data B_DATA, such as determining the ratio of the rapid acceleration section during the user's vehicle driving or the ratio of the vehicle's driving section and the neglect section based on the current change in the battery data B_DATA.

In some embodiments, the battery controller 21_5 may control the user's battery usage condition based on the user's driving tendency. For example, if there is a large section in which the amount of current output per unit time of the battery increases rapidly (i.e., if it is determined that the user performs a lot of rapid acceleration), the maximum output current value of the battery may be lowered. Alternatively, the variation range of the state of charge (SOC) may be adjusted based on the ratio between a driving section and a neglect section of the vehicle, or the battery cooling conditions may be modified according to the temperature data.

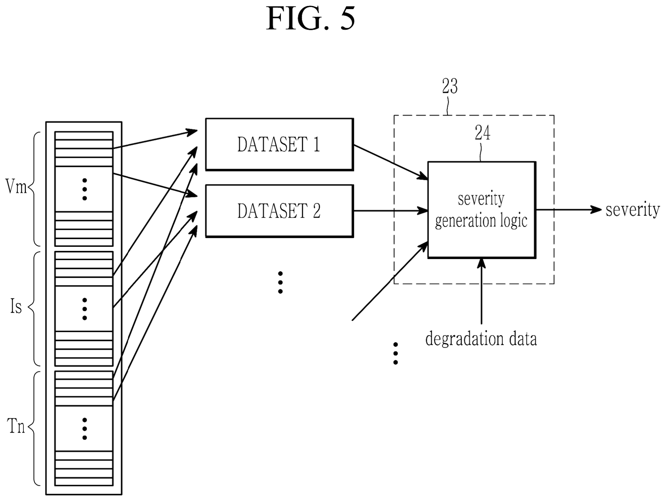

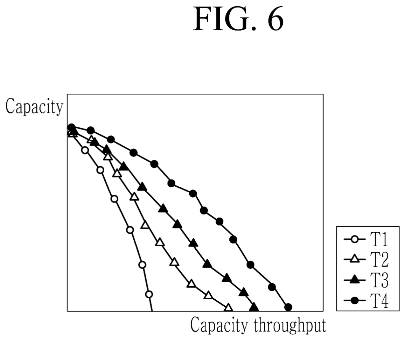

FIG. 5 shows a severity generator according to some embodiments, and FIG. 6 shows battery degradation data obtained by a battery manufacturer during an experiment or simulation process.

Battery manufacturers may obtain battery degradation data under various conditions through experiments or simulations. Specifically, the battery manufacturer may collect battery data indicating the status of the battery over time and obtain battery degradation data corresponding to the battery data by conducting an experiment to deteriorate the battery after the battery is first created. For example, a battery manufacturer may perform electrochemical impedance spectroscopy (EIS) during an experiment that degrades a battery and obtain battery degradation data using battery data obtained from EIS data. Hereinafter, battery data acquired in an experiment process by a battery manufacturer will be referred to as reference data.

The battery manufacturer may utilize a plurality of voltage data, a plurality of current data, and a plurality of temperature data of the battery cell as reference data together with time information. Referring to FIG. 5, a battery manufacturer may variously combine a plurality of voltage data Vm indicating a plurality of voltage status of the battery cell, a plurality of current data Is indicating a plurality of current status of the battery cell, and a plurality of temperature data Tn indicating a plurality of temperature status of the battery cell, and obtain battery degradation data according to various combinations of reference data through experiments or simulations.

Referring to FIG. 6, the graph of FIG. 6 represents degradation data of a battery when only temperature is a variable during an experiment or simulation process of a battery manufacturer. Through experiments or simulations, a battery manufacturer may acquire a change in battery capacity according to an increase in battery capacity throughput at various temperatures (e.g., T1, T2, T3, T4) as battery degradation data. For example, when voltage and current conditions are the same, the capacity of the battery decreases relatively quickly at the first temperature T1 than at the fourth temperature T4. That is, when the conditions of the voltage and the current are the same, the battery is relatively quickly degraded at the first temperature T1 from the fourth temperature T4.

Referring back to FIG. 5, in some embodiments, the severity generator 23 may receive a combination of reference data indicating the status of the battery as a data set. Specifically, the severity generator 23 may receive various combinations of reference data used by the battery manufacturer in the experiment or simulation process as a data set. Here, the reference data may be combined in various ways over time. For example, the first data set DATASET 1 may include the first voltage data V1, the first current data I1, and the first temperature data T1 at the first time, and the second data set DATASET 2 may include the second voltage data V2, the first current data 11, and the second temperature data T2 at the second time. In some embodiments, the severity generator 23 may further receive degradation data corresponding to the data set. Specifically, the severity generator 23 may receive a plurality of degradation data corresponding to a plurality of data sets acquired as an experiment or simulation result by a battery manufacturer.

In some embodiments, the severity generator 23 may include a severity generation logic 24. The severity generation logic 24 may receive a plurality of data sets and degradation data corresponding to the plurality of data sets and generate a battery severity based on the plurality of data sets and degradation data corresponding to the plurality of data sets. Battery severity may indicate the degree to which the data set affects the lifespan of the battery. The severity generation logic 24 may generate a plurality of data sets and a battery severity based on degradation data corresponding to the plurality of data sets as a degradation table or a look-up table.

The battery severity according to some embodiments may include a battery neglect severity and a battery driving severity. Specifically, the severity generator 23 may generate a battery neglect severity when the vehicle is in neglect status based on a plurality of degradation data corresponding to a plurality of data sets obtained as an experimental or simulation result. Here, the vehicle being in neglect status may refer to a status where the change over time of the current data within multiple data sets is zero, but is not limited thereto. The severity generator 23 may generate a battery driving severity when the vehicle is in driving status based on a plurality of degradation data corresponding to a plurality of data sets obtained as an experimental or simulation result. Here, the vehicle being in a driving status may refer to a status where the change over time of the current data within multiple data sets is not zero but is not limited thereto.

FIG. 7 illustrates a lifespan predictor according to some embodiments.

In some embodiments, the lifespan predictor 25 may include a predicted lifespan generator 220, a severity storage 230, and a lifespan prediction model storage 240.

In some embodiments, the lifespan predictor 25 may receive the battery data B_DATA from the data receiver 21_1 in the controller 21 (of FIG. 4). As described herein with reference to FIG. 4, the data receiver 21_1 may distinguish vehicle neglect status and vehicle driving status based on the battery data B_DATA. For example, if the current change amount is '0' for a given period of time, it is determined that the vehicle is in neglect status during that period of time, and the data may be transmitted to the neglect lifespan prediction logic 221 in the predicted lifespan generator 220. In addition, voltage data and temperature data corresponding to the corresponding time period may be transmitted to the neglect lifespan prediction logic 221 in the predicted lifespan generator 220. Alternatively, if the current change amount is not '0' for a given period of time, it is determined that the vehicle is driving status during that period of time, and the data may be transmitted to the driving lifespan prediction logic 223 in the predicted lifespan generator 220. In addition, voltage data and temperature data corresponding to the corresponding time period may be transmitted to the driving lifespan prediction logic 223 in the predicted lifespan generator 220.

However, here, it has been described that the lifespan predictor 25 receives the battery data B_DATA from the data receiver 21_1 in the controller 21 (of FIG. 4), but is not limited thereto. For example, the lifespan predictor 25 may further include a separate data receiver that receives battery data B_DATA and distinguishes between vehicle neglect status and vehicle driving status data based on battery data B_DATA.

In some embodiments, the predicted lifespan generator 220 may generate a predicted lifespan of the battery based on the received battery data B_DATA. In some embodiments, the predicted lifespan generator 220 may receive the battery severity stored in the severity storage 230 and the lifespan prediction model stored in the lifespan prediction model storage 240. The battery severity stored in the severity storage 230 may include a battery neglect severity and a battery driving severity.

In some embodiments, the neglect lifespan prediction logic 221 in the predicted lifespan generator 220 may output the predicted lifespan of the battery by using the battery neglect severity received from the severity storage 230 and the lifespan prediction model received from the lifespan prediction model storage 240. Specifically, when predicting the lifespan of the battery according to the battery data B _ DATA, the neglect lifespan prediction logic 221 may use the battery neglect severity as a coefficient of the lifespan prediction model. The neglect lifespan prediction logic 221 may output a predicted battery lifespan in a battery neglect status by using neglect severity and lifespan prediction model.

In some embodiments, the driving lifespan prediction logic 223 in the predicted lifespan generator 220 may output the predicted lifespan of the battery by using the battery driving severity received from the severity storage 230 and the lifespan prediction model received from the lifespan prediction model storage 240. Specifically, when predicting the lifespan of the battery according to the battery data B _ DATA, the driving lifespan prediction logic 223 may use the battery driving severity as a coefficient of the lifespan prediction model. The driving lifespan prediction logic 223 may output a predicted battery lifespan in a battery driving status by using a battery driving severity and lifespan prediction model.

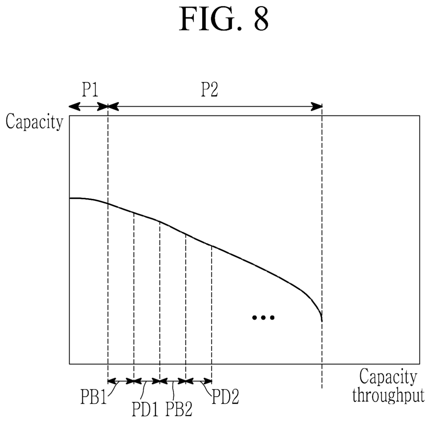

FIG. 8 illustrates a predicted lifespan of a battery according to some embodiments.

Referring to FIG. 8, the predicted lifespan generator 220 may predict the lifespan of the battery in the second period P2, based on the battery data B_DATA obtained in the first period P1. The predicted lifespan generator 220 may output the predicted lifespan of the battery in the second period P2 based on the predicted lifespan of the battery in the battery neglect status and the predicted lifespan of the battery in the battery driving status.

In some embodiments, the predicted lifespan generator 220 may output the predicted lifespan of the battery using the battery severity and the lifespan prediction model based on the battery data B_DATA. The predicted lifespan generator 220 may predict the battery lifespan (PB1, PB2, ...) in the vehicle neglect status by using the battery neglect severity and lifespan prediction model based on the battery data B_DATA received in the vehicle neglect status. The predicted lifespan generator 220 may predict the battery lifespan (PD1, PD2, ...) in the vehicle driving status by using the battery driving severity and lifespan prediction model based on the battery data B_DATA received in the vehicle driving status. Here, the capacity throughput of the vehicle neglect status and the vehicle driving status is shown to be similar but is not limited thereto. For example, according to the battery usage pattern of the user, it may be predicted that the capacity throughput in the vehicle driving status is relatively greater than the capacity throughput in the vehicle neglect status. Alternatively, it may be predicted that the capacity in the vehicle driving status of the vehicle decreases relatively faster than the capacity in the vehicle neglect status according to the battery usage pattern of the user.

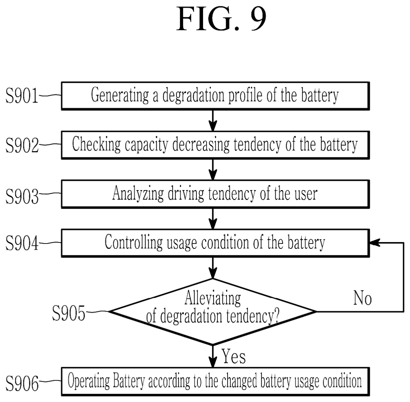

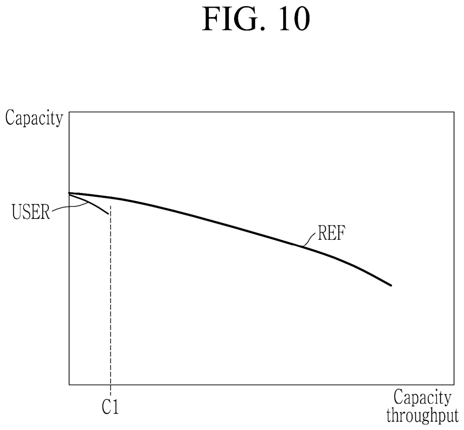

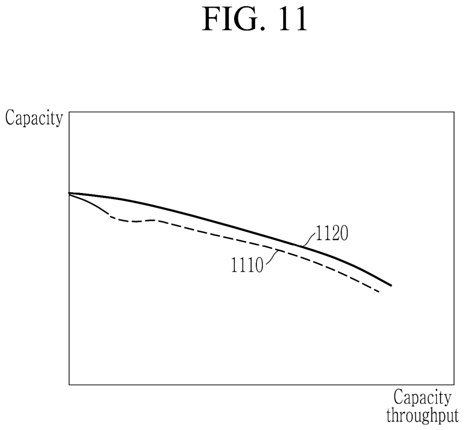

FIG. 9 is a flowchart illustrating a method of operating a battery control apparatus according to some embodiments, and FIGS. 10 and 11 illustrate a degradation profile of a battery according to some embodiments.

In some embodiments, the battery control apparatus 20 (of FIG. 1) may calculate the capacity change of the battery based on the battery data indicating the battery usage pattern of the user, and generate a degradation profile of the battery S901. Specifically, the battery control apparatus 20 may calculate a battery capacity change according to the battery data in a predetermined time interval. Referring to FIG. 10, the battery control apparatus 20 may receive battery data indicating a battery usage pattern of a user and calculate a battery capacity change according to the battery data until the capacity throughput becomes a predetermined value C1.

In some embodiments, the battery control apparatus 20 may check the capacity decreasing tendency of the battery S902. Specifically, change in capacity of the battery acquired based on the battery data is compared with the change in the capacity of the battery of the reference user, and it may be confirmed that the battery of the user is deteriorated faster than the battery of the reference user. Referring to FIG. 10, the battery control apparatus 20 may determine that the battery of the user is deteriorated faster than the battery of the reference user REF, based on a change in the battery capacity of a user until the capacity throughput becomes a predetermined value C1.

In some embodiments, the battery control apparatus 20 may analyze the driving tendency of the user based on the battery data S903. For example, based on the amount of current change in the battery data, the driving tendency of the user may be analyzed based on the battery data, such as determining the ratio of the rapid acceleration section or the ratio of the driving section and the neglect section of the vehicle while driving the vehicle.

In some embodiments, the battery control apparatus 20 may control the battery usage condition to reduce the capacity decreasing tendency of the battery based on the driving tendency of the user S904. For example, the maximum output current value or the SOC variation width of the battery may be adjusted or the battery cooling condition may be changed according to the driving tendency of the user.

In some embodiments, the battery control apparatus 20 may determine whether the degradation tendency of the battery is mitigated according to the changed battery usage condition S905. Specifically, the battery control apparatus 20 may predict the lifespan of the battery based on the changed battery usage condition. Specifically, the lifespan of the battery may be predicted while changing the battery data of the user according to the changed battery usage condition. For example, when the maximum output current value of the battery is lowered in the battery usage condition, the lifespan of the battery may be predicted while adjusting the maximum value of the current data among the battery data. Alternatively, when the cooling condition is enhanced in the battery usage condition, the lifespan of the battery may be predicted while adjusting the temperature data among the battery data. The battery control apparatus 20 may predict the lifespan of the battery according to the changed battery usage condition by using the battery lifespan prediction model and the battery severity. Referring to FIG. 11, the battery control apparatus 20 may confirm that the degradation tendency of the predicted battery lifespan 1110 is alleviated according to the changed battery usage condition. The battery control apparatus 20 may confirm that the degradation tendency of the predicted battery lifespan 1110 according to the changed battery usage condition is relaxed to the degradation level of the reference degradation profile 1120.

In some embodiments, the battery control apparatus 20 may operate the battery module under the changed battery usage condition when the degradation tendency of the predicted battery lifespan according to the changed battery usage condition is alleviated S906. Accordingly, it is possible to optimize the usage condition of the battery in various battery usage patterns and to improve the performance of the battery.

The herein-described embodiments are not implemented only through the apparatus and/or method described herein, and may be implemented through a program for realizing a function corresponding to the configuration of embodiments, or a computer-readable recording medium having the program recorded thereon, and such an implementation may be easily implemented by a person skilled in the art to which the present disclosure pertains from the description of the embodiments described herein. The computer-readable recording medium includes all kinds of recording devices in which data readable by a computer system is stored. Examples of the computer readable recording medium include read-only memory (ROM), random-access memory (RAM), CD-ROM, DVD-ROM, DVD-RAM, magnetic tapes, floppy disks, hard disks, and optical data storage devices.

## Claims

1. A battery system (1) comprising:
a battery module (10) comprising a plurality of battery cells (11), and
a battery control apparatus (20) configured to detect a plurality of battery data (B_DATA) indicating the status of the plurality of battery cells (11) through electrochemical impedance spectroscopy, EIS,, generate a degradation profile (USER A, USER B) of the plurality of battery cells (11) based on the plurality of battery data (B_DATA), and control usage conditions of the plurality of battery cells (11) based on a comparison result between the degradation profile (USER A, USER B) and a reference degradation profile (ref).

2. The battery system (1) as claimed in claim 1, wherein:
the battery control apparatus (20) is configured to predict a lifespan of the plurality of battery cells (11) using a lifespan prediction model based on the plurality of battery data (B_DATA).

3. The battery system (1) as claimed in claim 2, wherein:
the battery control apparatus (20) is configured to generate, as a factor of the lifespan prediction model, a battery severity based on a plurality of combinations of reference data and a plurality of degradation data obtained through simulation for the plurality of combinations of reference data.

4. The battery system (1) as claimed in claim 3, wherein:
the reference data (DATASET 1, DATASET 2) comprises the plurality of battery data (B_DATA) detected through EIS for the plurality of battery cells (11) used in the simulation.

5. The battery system (1) as claimed in any of claims 1 to 4, wherein:
the battery control apparatus (20) is configured to detect the plurality of battery cells (11) until a capacity throughput of the plurality of battery cells (11) becomes a first value (V1), and to predict a capacity change of the plurality of battery cells (11) with respect to a portion where the capacity throughput exceeds the first value (V1) based on the plurality of battery data (B_DATA).

6. The battery system (1) as claimed in any of claims 1 to 5, wherein:
the plurality of battery data (B_DATA) comprises voltage data, current data, and temperature data of the plurality of battery cells (11).

7. The battery system (1) as claimed in and of claims 1 to 6, wherein:
the degradation profile (USER A, USER B) and the reference degradation profile (ref) represent a capacity change according to a capacity throughput of the plurality of battery cells (11).

8. The battery system (1) as claimed in any of claims 1 to 7, wherein:
the usage conditions comprise at least one of a maximum output current value of the plurality of battery cells (11), a state of charge, SOC, range, and a degree of cooling applied to the plurality of battery cells (11).

9. The battery system (1) as claimed in any of claims 1 to 8, wherein the battery control apparatus (20) comprises:
a controller (21) configured to detect the plurality of battery data (B_DATA. ref), generate the degradation profile (USER A, USER B), and change the usage conditions of the plurality of battery cells (11) based on a comparison result between the degradation profile (USER A, USER B) and the reference degradation profile (ref),
a lifespan predictor (25) configured to adjust values of the plurality of battery data (B_DATA) according to the change of the usage conditions, and predict a lifespan (1110) of the plurality of battery cells (11) using a lifespan prediction model based on the adjusted values of the plurality of battery data (B_DATA), and
a severity generator (23) configured to generate a battery severity indicating a degree to which the plurality of battery data (B_DATA) affects the lifespan of the plurality of battery cells (11) as a coefficient of the lifespan prediction model.

10. The battery system (1) as claimed in claim 9, wherein:
the controller (21) is configured to determine that a capacity decreasing tendency of the degradation profile (USER A, USER B) is greater than a capacity decreasing tendency of the reference degradation profile (ref) by comparing the degradation profile (USER A, USER B) with the reference degradation profile (ref), and analyze a user's driving tendency based on the plurality of battery data (B_DATA).

11. An operating method of a battery control apparatus comprising:
receiving a plurality of battery data (B_DATA) indicating status of a plurality of battery cells (11) obtained through electrochemical impedance spectroscopy, EIS,
generating (S901) a degradation profile (USER A, USER B) of the plurality of battery cells (11) based on the plurality of battery data (B_DATA),
analyzing (S903) a driving tendency of a user based on the plurality of battery data (B_DATA),
controlling (S904) usage conditions of the plurality of battery cells (11) based on a comparison result of the degradation profile (USER A, USER B) and a reference degradation profile (ref) of the plurality of battery cells (11) and the driving tendency, and
predicting a lifespan of the plurality of battery cells (11) based on the usage conditions of the plurality of battery cells (11).

12. The operating method as claimed in claim 11, wherein:
the degradation profile (USER A, USER B) represents a change in capacity according to the capacity throughput of the plurality of battery cells (11), and
wherein generating (S901) the degradation profile (USER A, USER B) of the plurality of battery cells (11) comprises:
receiving the plurality of battery data (B_DATA) until the capacity throughput becomes a first value (V1), and
calculating a capacity change of the plurality of battery cells (11) based on the plurality of battery data (B_DATA).

13. The operating method as claimed in claim 12, wherein the predicting the lifespan of the plurality of battery cells (11) based on the usage conditions of the plurality of battery cells (11) comprises:
changing values of the plurality of battery data (B_DATA) based on the usage conditions of the plurality of battery cells (11), and
predicting a change in capacity of the plurality of battery cells (11) with respect to a portion in which the capacity throughput exceeds the first value (V1) based on the changed values of the plurality of battery data (B_DATA).

14. The operating method as claimed in claim 13, wherein the predicting a capacity change of the plurality of battery cells (11) with respect to the portion in which the capacity throughput exceeds the first value (V1) based on the changed values of the plurality of battery data (B_DATA) comprises:
generating a battery severity as a coefficient of a lifespan prediction model based on a plurality of combinations of reference data and a plurality of degradation data obtained as a simulation result of the plurality of combinations of the reference data, and
predicting a capacity change of the plurality of battery cells (11) using the lifespan prediction model based on the changed values of the plurality of battery data (B_DATA) and the battery severity.

15. The operating method as claimed in claim14, wherein:
the reference data is a plurality of battery data (B_DATA) detected through EIS for a plurality of battery cells (11) for the simulation.
